# EUROPEAN PATENT SPECIFICATION

(11) **EP 2 696 238 B1**
(45) Date of publication and mention of the grant of the patent: **27.07.2016**
(21) Application number: 13178467.0
(22) Date of filing: 30.07.2013
(51) Int. Cl.: G02F 1/1343, G02F 1/1362, G09G 3/36

(54) **Driving method for liquid crystal display**
Ansteuerungsverfahren für Flüssigkristallanzeigen
Procédé de commande d'afficheurs à cristaux liquides

(30) Priority: 09.08.2012 CN 201210282801
(43) Date of publication of application: 12.02.2014
(73) Proprietor: BOE Technology Group Co., Ltd., Beijing 100015 (CN); Hefei BOE Optoelectronics Technology Co., Ltd., Hefei, Anhui 230012 (CN)
(72) Inventor: Hu, Ming, 100176 Beijing (CN)
(74) Representative: Brötz, Helmut

(56) References cited:
- US-A- 6 075 505
- US-A1- 2007 222 907
- US-A1- 2010 245 224
- US-A1- 2011 304 787

## Description

### TECHNICAL FIELD OF THE DISCLOSURE

The present disclosure relates to the technical field of Liquid Crystal Display, and particularly to a pixel unit, a pixel structure, a display apparatus and a pixel driving method.

### BACKGROUND

Thin Film Transistor-Liquid Crystal Display (hereinafter referred to as TFT-LCD) has the advantages of light weight, thin thickness, low power consumption, etc. and has been widely used in electronic products such as TVs, cell-phones, displays, etc. In order to develop TFT-LCDs with low cost and high quality, in the prior art, a technique called Dual Gate is usually adopted to drive pixels, so that pixel charging time can be reduced and picture display with low cost and high quality can be achieved.

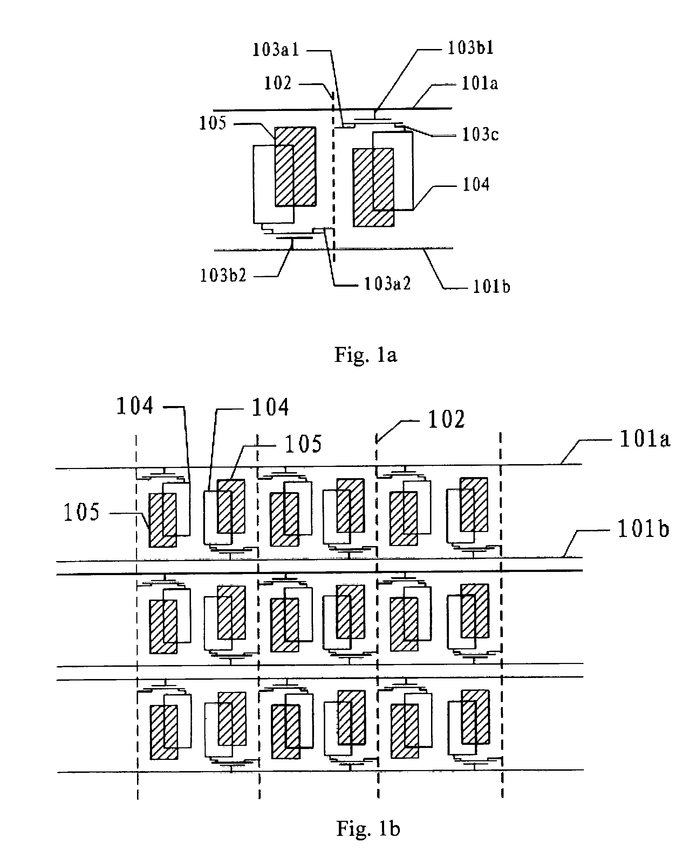

A schematic structure diagram of an existing pixel unit is shown in Fig.1a, the pixel unit includes two adjacent pixels located in a same row, each of the two adjacent pixels includes a pixel electrode, a common electrode and a Thin-Film Transistor TFT for driving the corresponding pixel. In a pixel structure adopting the technique called Dual Gate, in order to drive pixels, the pixel electrodes of the two pixels in each pixel unit are connected to a same data line via sources of corresponding TFTs respectively, and the gates of the TFTs are connected to different gate lines. In Fig.1a, a same data line 102 is connected to sources 103a1 and 103a2 of TFTs in the side-by-side adjacent two pixels, different gate lines 101a and 101b are connected to gates 103b1 and 103b2 of TFTs in the two pixels, and each pixel includes two transparent electrodes located at different layers, wherein a first transparent electrode layer 104 is connected to a drain 103c of TFT as a pixel electrode and a second transparent electrode layer 105 is used as a common electrode. Several pixel units can constitute a pixel structure, and a schematic diagram of an existing pixel structure is shown in Fig.1b, in such pixel structure, the pixel electrode of each pixel unit is formed by the first transparent electrode layer 104, and the common electrode of each pixel unit is formed by the second transparent electrode layer 105.

In order to avoid aging of liquid crystal in a direct current electric field, it is necessary to change polarity of voltage across liquid crystal molecules continuously, so as to achieve a pixel dot-inversion, column-inversion, frame-inversion and so on. In order to improve quality of a whole display picture, a pixel dot-inversion driving manner has progressively become a domain display manner.

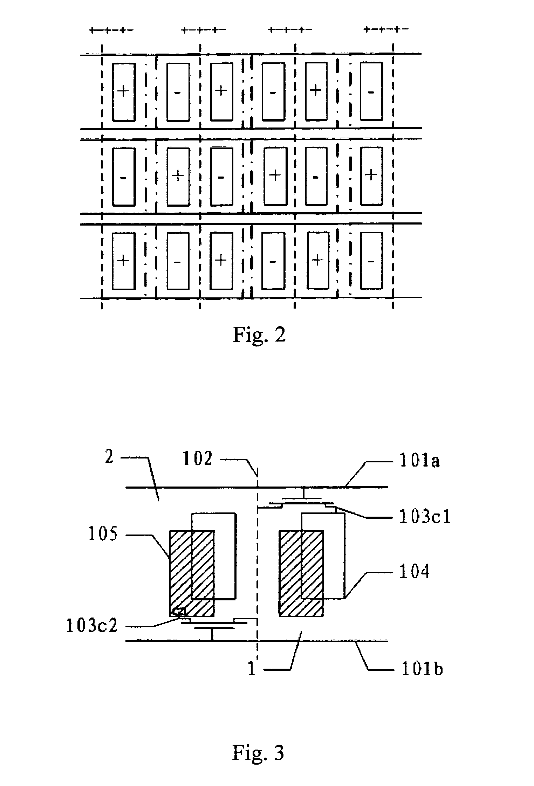

In a conventional Dual-Gate pixel structure, for example, the pixel structure as shown in Fig.1b, a data signal line is used to simultaneously drive two side-by-side adjacent symmetric pixels, so that the number of data signal lines is reduced by half. However, in order to accomplish the pixel dot-inversion, it is necessary for the data signal lines to change polarity of data signals provided to pixels continuously, that is, to output positive and negative signals to pixels alternately. As shown in Fig.2, it is a data signal writing manner when the pixel dot-inversion is performed by the conventional Dual Gate pixel structure, wherein pixel dots with symbol "+" represent the pixel dots which are charged by positive charges, and pixel dots with symbol "-" represent the pixel dots which are charged by negative charges, a switching frequency of data signal lines is increased largely and it is necessary to make the polarity of voltage of the input data signal be inverted, which causes the power consumption to be increased largely. In case of a same resolution, pixel charging time according to the above-mentioned Dual Gate technique is short and is only half of the charging time in the conventional pixel structure. With the improvement of the resolution of products, the problem in charging of pixels becomes more and more critical. In the prior art from US 2007/0222907 A1 it is known a liquid crystal display device. US 2010/0245224 A1 discloses a LCD electrode arrangement. Furthermore, from US 2011/0304787 A1 is known an array substrate, a liquid crystal penal, a liquid crystal display and a driving method thereof. US 6075505 discloses a driving method for an AMLCD having a double gate structure.

### SUMMARY

In the present description , "disclosure" does not correspond to the invention. The invention is defined in the appended claims and illustrated in explicit "embodiments of the invention". Embodiments of the present disclosure provide a TFT-LCD pixel structure and a pixel driving method capable of solving the problem of large power consumption due to the necessity of frequently changing polarity of voltage of the data signals input to respective data lines.

One aspect of the present disclosure provides a pixel unit adopting a Dual Gate driving technique, wherein the pixel unit comprises a first pixel and a second pixel located in a same row and adjacent to each other, each pixel includes two transparent electrode layers and a Thin Film Transistor TFT, the two transparent electrode layers are used as a pixel electrode and a common electrode respectively, a source of a TFT for driving the first pixel and a source of a TFT for driving the second pixel are connected to a same data line, and gates thereof are connected to different gate lines, wherein

in the first pixel, the first transparent electrode layer is connected to a drain of the TFT for driving the first pixel and used as the pixel electrode of the first pixel, and the second transparent electrode layer is used as the common electrode of the first pixel;

in the second pixel, the second transparent electrode layer is connected to a drain of the TFT for driving the second pixel and used as the pixel electrode of the second pixel, and the first transparent electrode layer is used as the common electrode of the second pixel.

Another aspect of the present disclosure further provides a pixel structure including an array formed by a plurality of pixel units as described above.

In an example, in the array formed by the pixel units, in each row, the first pixels and the second pixels included in any two adjacent pixel units are arranged alternately.

In an example, in each row and each column of the array, the first pixels and the second pixels included in any two adjacent pixel units are arranged alternately.

Yet another aspect of the present disclosure further provides a pixel driving method including: in process of displaying a frame of picture, inputting data signals with a same polarity of voltage to respective data lines for driving a first pixel and a second pixel in each pixel unit; or changing polarity of voltage of data signal input to data line every two rows for driving a first pixel and a second pixel in each pixel unit.

The present disclosure further provides a display apparatus including any of the above-described pixel structures.

With the pixel unit, the pixel structure, the display apparatus and the pixel driving method provided in the present disclosure, by changing positions of the pixel electrode and the common electrode in two adjacent pixels driven by a same data line in a pixel unit, when pixel driving is performed, the pixel dots corresponding to the two adjacent pixels can have different polarities of voltages and thus power consumption is reduced, without changing the polarity of voltage of the data signal on the same data line for driving the two adjacent pixels.

### BRIEF DESCRIPTION OF THE DRAWINGS

Fig.1a is a schematic structure diagram of a pixel unit in prior art;
Fig.1b is a schematic diagram of a pixel structure in prior art;
Fig.2 is a data signal writing manner when a pixel dot-inversion is performed in the pixel structure in prior art;
Fig.3 is a schematic structure diagram of a pixel unit provided in a first embodiment of the present disclosure;
Fig.4a is a schematic diagram of a pixel structure provided in a second embodiment of the present disclosure;
Fig.4b is a writing manner of data signals when a pixel column-inversion is performed according to embodiments of the present disclosure;
Fig.4c is a data signal writing manner when a pixel dot-inversion is performed according to embodiments of the invention;
Fig.5a is a schematic diagram of another pixel structure provided in the second embodiment of the present disclosure;
Fig.5b is another data signal writing manner when a pixel dot-inversion is performed according to embodiments of the present disclosure; and
Fig.5c is another data signal writing manner when a pixel column-inversion is performed according to embodiments of the invention.

### DETAILED DESCRIPTION

In existing pixel units, there are two different transparent electrode layers, wherein one is used as a pixel electrode and the other is used as a common electrode, and the voltage difference formed by the pixel electrode and the common electrode drives pixels to display a picture. The pixel unit commonly used in the Advanced Display System is a typical pixel unit with two transparent electrode layers. In an AD-SDS (Advanced-Super Dimensional Switching, hereinafter referred to as ADS) wide viewpoint technique, in an ADS mode, a multidimensional electric field is formed by electric field generated by edges of slit electrodes in a same plane and electric field generated by a slit electrode layer and a plate electrode layer, so that liquid crystal molecules with all orientations between and above the slit electrodes in a liquid crystal cell can rotate, and the operating efficiency of liquid crystal is increased and the light transmission efficiency is also increased. The pixel electrode or common electrode in ADS can be set as a slit electrode or a plate electrode according to a specific condition. However, in the existing pixel units, in each pixel unit, transparent electrodes in a layer are used as pixel electrodes and transparent electrodes in another layer are used as common electrodes. Embodiments of the present disclosure provide a pixel unit, in two adjacent pixels in the pixel unit, positions of pixel electrodes and common electrodes are exchanged, the pixel unit is used in TFT-LCD adopting the Dual Gate technique, and the two adjacent pixels are driven by a same data line and different gate lines, so that the polarity of the pixel dots corresponding to the adjacent pixels can be changed without the need for changing the polarity of voltages when data signals are written.

As shown in Fig.3, it is a schematic structure diagram of the pixel unit provided in a first embodiment of the present disclosure. The pixel unit includes a first pixel 1 and a second pixel 2 adjacent to each other, which are located in a row, and driven by two TFTs connected to a same data line 102 and different gate lines 101a and 101b.

Particularly, in the first pixel 1, a first transparent electrode layer 104 is connected to a drain 103c1 of TFT for driving the first pixel 1 and used as a pixel electrode of the first pixel 1, and a second transparent electrode layer 105 is used as a common electrode of the first pixel 1.

In the second pixel 2, the second transparent electrode layer 105 is connected to a drain 103c2 of TFT for driving the second pixel 2 and used as a pixel electrode of the second pixel 2, and the first transparent electrode layer 104 is used as a common electrode of the second pixel 2.

Preferably, the two transparent electrode layers in the pixel unit can be formed by Indium Tin Oxide, ITO.

Preferably, in the existing pixel unit structure, the first transparent electrode layer is used as the pixel electrode and the second transparent electrode layer is used as the common electrode. In order to simplify the process of manufacturing, in the process of implementation of the embodiment of the present disclosure, the second transparent electrode layer 105 as the pixel electrode in the second pixel 2 can be connected to the drain 103c2 of TFT through a via hole without changing the relationship between the layers in the original pixel unit.

In the pixel unit provided in the embodiment of the present disclosure, positions of the pixel electrodes and the common electrodes in two adjacent pixels driven by a same data line are exchanged, so that the positive and negative polarity of the pixel dots corresponding to the adjacent pixels can be changed without the necessity of changing the polarity of voltage frequently when data signals are written.

A second embodiment of the present disclosure provides a pixel structure including an array formed by the pixel unit of the first embodiment.

Preferably, in the pixel structure array provided in the embodiment of the present disclosure, the first pixels and the second pixels included in the adjacent pixel units in each row are arranged alternately.

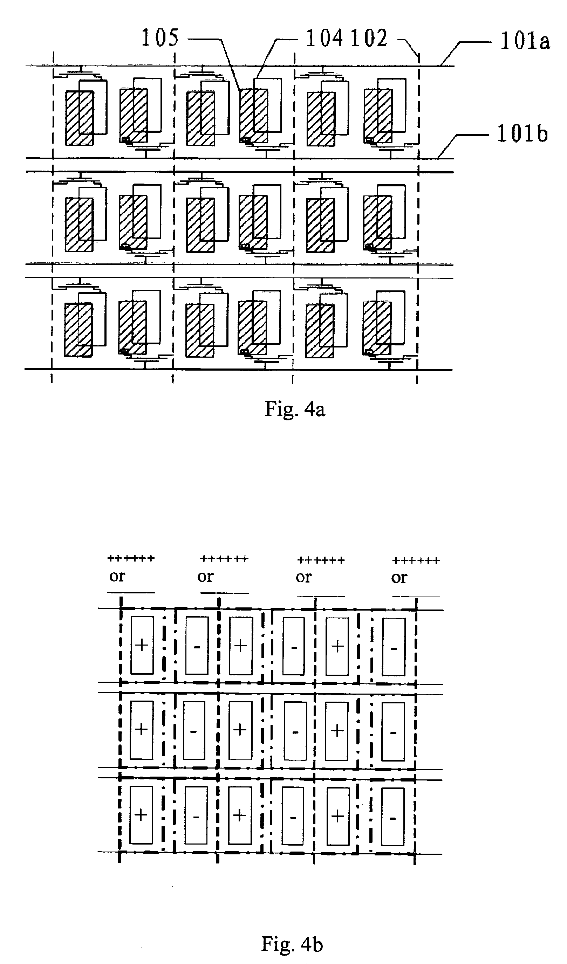

Furthermore, in the pixel structure array provided in the embodiment of the present disclosure, each row and each column are constituted by pixel units with a same structure, that is, in each row of the array, the first pixels and the second pixels included in any two adjacent pixel units are alternately arranged in the horizontal direction; in each column of the array, the first pixels and the second pixels included in any two adjacent pixel units are aligned respectively in the vertical direction. Particularly, when a pixel structure is designed, the pixel unit structure in the first embodiment can be used in each row and each column in the array, the method for setting the first pixel in the first embodiment can be applied to a first pixel in a first row, that is, the first transparent electrode layer 104 is used as a pixel electrode, the second transparent electrode layer 105 is used as a common electrode; the method for setting the second pixel can be applied to a second pixel in the first row, that is, the first transparent electrode layer 104 is used as a common electrode, the second transparent electrode layer 105 is used as a pixel electrode; the method for setting the first pixel in the first embodiment can be applied to a third pixel in the first row; the method for setting the second pixel in the first embodiment can be applied to a fourth pixel in the first row. In each row of the array, in side-by-side adjacent pixel units, the first pixels and the second pixels are arranged alternately. Moreover, the same method as that for setting pixels in the first row is applied to other rows in the array. Consequently, pixels arranged in the vertical direction in each column of the array have the same structure, may be the first pixel or the second pixel, and a final pixel structure is as shown in Fig.4a.

More preferably, when a pixel structure array is designed, the first pixel and second pixel in any two adjacent pixel units in each row and in each column are arranged alternately.

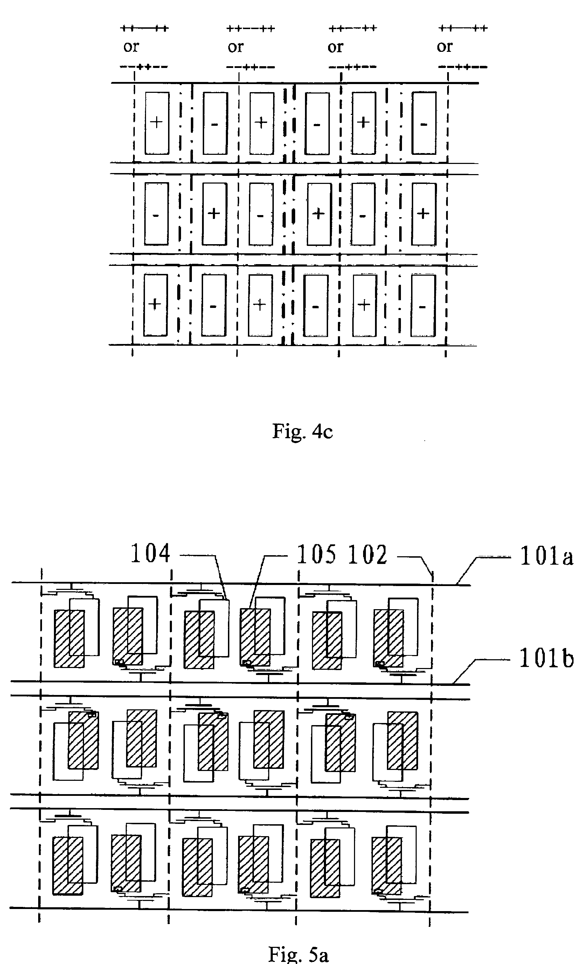

Particularly, in a pixel structure as shown in Fig.5a, the transparent electrodes being the pixels electrodes in any two adjacent pixels are different, the method for setting the first pixel in the first embodiment can be applied to a first pixel in a first row, that is, the first transparent electrode layer 104 is used as a pixel electrode, the second transparent electrode layer 105 is used as a common electrode; the method for setting the second pixel in the first embodiment can be applied to a second pixel in the first row, that is, the first transparent electrode layer 104 is used as a common electrode, the second transparent electrode layer 105 is used as a pixel electrode; the method for setting the first pixel in the first embodiment can be applied to a third pixel in the first row; the method for setting the second pixel in the first embodiment can be applied to a fourth pixel in the first row. Then, in a second row in the array, positions of the first pixels and the second pixels are exchanged as compared with those in the first row, that is, the method for setting the second pixel in the first embodiment can be applied to a first pixel in the second row; the method for setting the first pixel in the first embodiment can be applied to a second pixel in the second row, and so on. That is, in the structure of the array, in each row and in each column, the first pixels and the second pixels are arranged alternately in any two adjacent pixel units.

With the above-described pixel structure provided in the embodiment of the present disclosure, positions of the pixel electrodes and the common electrodes are exchanged in two adjacent pixels, and sources of two TFTs for driving the two adjacent pixels respectively are connected to a same data line, and gates of the two TFTs are connected to different gate lines, therefore alternating of positive and negative polarity of the pixel dots corresponding to the adjacent pixels can be achieved without changing the polarity of the voltage of the data signals input to the data lines frequently, thus reducing number of voltage flipping of the data signals and reducing power consumption accordingly.

A third embodiment of the present disclosure provides a pixel driving method applied to the above-described pixel structure.

In the pixel driving method provided in the third embodiment of the present disclosure, in the process of displaying a frame of picture, each data line is supplied with data signal with a same polarity to drive the first pixel and the second pixel in each pixel unit in the array, so that polarities of the voltage differences between the two transparent electrode layers in each pixel are the same, which means that the voltage of the first transparent electrode layer is larger than or smaller than that of the second transparent electrode layer in each pixel. However, since the pixel electrodes and the common electrodes in the first pixel and the second pixel of each pixel unit are exchanged, the polarities of the voltage differences between the pixel electrode and the common electrode in the first pixel and the second pixel are contrary to each other. Consequently, in the embodiment of the present disclosure, even if each data line is supplied simultaneously with a same data signal in a whole picture, polarity may be changed in two adjacent pixels in a same pixel unit.

Particularly, description will be given to an example of the embodiment of the present disclosure wherein data signal with positive polarity is input, while this example has no limitation on the present disclosure. When data signal with positive polarity is input to the data line, the TFT connected to a first gate line is turned on and drives pixels in the pixel structure (that is, pixels in odd columns in the first row of the array), so that the voltage of the first transparent electrode layer being the pixel electrode in the first row is larger than the voltage of the second transparent electrode layer being the common electrode, the voltage difference between the two transparent electrode layers has a positive polarity, and the corresponding pixel dots are charged with positive charges. As such, the same data signal is input, the TFT connected to a second gate line is turned on and drives pixels in the pixel structure (that is, pixels in even columns in the first row of the array), the voltage of the first transparent electrode layer is still larger than the voltage of the second transparent electrode layer, the voltage difference between the two transparent electrode layers has a positive polarity, however the voltage of the second transparent electrode layer being the pixel electrode is lower than that of the first transparent electrode layer being the common electrode since positions of the pixel electrode and the common electrode are exchanged, and thus the corresponding pixel dots are charged with negative charges. Similarly, polarity of charges changes alternately in the pixel dots in pixel units in other rows of the array.

Preferably, in the embodiment of the present disclosure, when each data line in the pixel structure as shown in Fig.4a is supplied with a same data signal, since a first pixel and a second pixel are alternately arranged in the horizontal direction in the adjacent pixels in each row of the array, the pixels arranged in the vertical direction in each column are the same, when the same data signal is input, the pixel column-inversion can be achieved, as shown in Fig.4b.

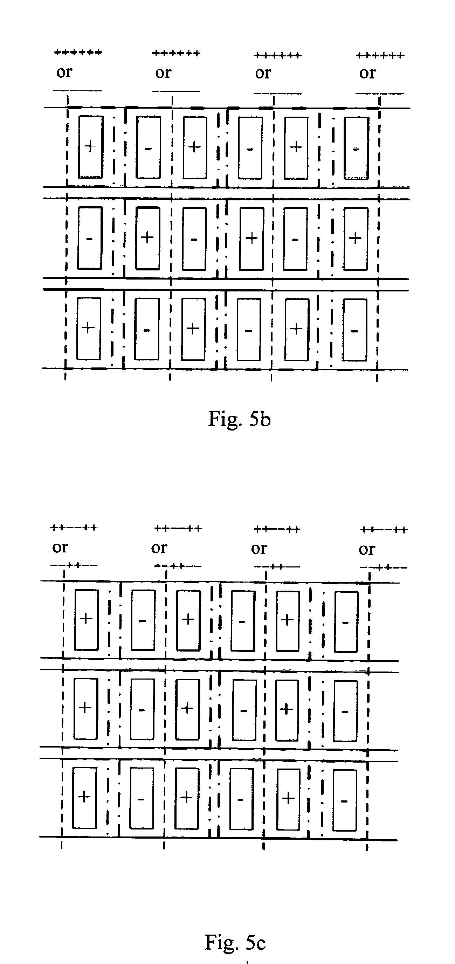

Preferably, in the embodiment of the present disclosure, when each data line in the pixel structure as shown in Fig.5a is supplied with a same data signal, since a first pixel and a second pixel are alternately arranged in the pixel units in each row and each column of the array, so that the pixel dots corresponding to any two adjacent pixels in the array are charged with charges of different polarity, that is, the polarities of any two adjacent pixels are contrary to each other. Therefore, when data signal with the same polarity of voltage is input in Fig.5a, a pixel dot-inversion can be achieved, as shown in Fig.5b.

With the above-described pixel driving method provided in the embodiment of the present disclosure, a frequency of signal flipping is reduced, and since the data signals input in a whole picture has a same polarity, the voltage of the signals has a small fluctuation range, and the power consumption of liquid crystal display is reduced.

In addition, with the above-described pixel driving method provided in the embodiment of the present disclosure, since positive signal or negative signal is input in a whole frame during the playback of picture is, and since the Dual Gate technique is applied, the current pixel is charged with a part of charges when a previous pixel is charged. Therefore, with the pixel driving method provided in the embodiment of the present disclosure, pre-charging of pixels can be achieved, thus expediting the charging to pixels and saving the charging time.

More preferably, in the embodiment of the present disclosure, during the display of two adjacent frames of picture, the polarity of the voltage of each of the data signals input to respective data lines can be changed, so that the polarities of the voltage differences between the two transparent electrode layers of the same pixel in the two adjacent frames are contrary to each other, thus a pixel frame-inversion between two adjacent frames can be achieved.

A fourth embodiment of the present disclosure further provides a pixel driving method, wherein there is no need for the data signal lines to input data signals with positive, negative, positive and negative polarities to pixels. In the embodiment of the present invention, during the process of display a frame of picture, the polarity of the voltages of data signals input to the data lines are changed every two rows, so that the polarities of the voltage differences between the two transparent electrode layers in a same row are the same, and the polarities of the voltage differences between the two transparent electrode layers in two adjacent rows are contrary to each other. The polarity of the voltage of data signal input to the data line is changed every two rows, which means that the polarity of the voltage of data signal input to the same data line is changed once during the time for scanning every two gate lines. That is, the polarities of the voltage of the data signal input the same data line during the time for scanning two successive gate lines are the same, which is referred to as one flipping per two lines.

In the embodiment of the present invention, the first pixels and the second pixels are arranged alternately in each row of the array, positions of a transparent electrode being the pixel electrode and a transparent electrode being the common electrode are exchanged in adjacent pixels, therefore polarities of the pixel dots corresponding to two adjacent pixels in a same row may change when data signals with a same polarity are input to each column of the array.

In the pixel structure as shown in Fig.4a, the pixel arrangement in the second row of the array is the same as that in the first row of the array, therefore the polarity of voltages of the input data signals is changed in the second row of the array (that is, a third gate line), so that the polarities of the voltage differences between the two transparent electrode layers in pixels of the second row and the first row are contrary to each other, which makes the polarity of voltages of pixel dots of the second row different from that of the first row, and so on. By changing the input data signal every two rows, the pixel dots corresponding to pixels in two adjacent rows have voltages with different polarities, thus a pixel dot-inversion may be achieved. Fig.4c. shows a signal writing manner of the embodiment of the present disclosure for implementing the pixel dot-inversion when applying the following data signals to the pixel structure as shown in Fig.4a., that is, changing the data signals input to the data lines every two rows so that the polarities of the voltage differences between the two transparent electrode layers in a row are the same and the polarities of the voltage differences between the two transparent electrode layers in the two adjacent rows are contrary to each other.

In the pixel structure shown in Fig.5a, the pixel arrangement of the second row of the array is different from that of the first row of the array, when the polarity of the voltages of the input data signals in the second row of the array (that is, the third gate line) is changed, the polarity of the voltage difference between the two transparent electrode layers in the pixel of the second row is different to that in a corresponding pixel (that is, in a same column) of the first row; since a transparent electrode being the pixel electrode and a transparent electrode being the common electrode in the second row are exchanged in the position as compared to the first row, therefore the polarity of the voltage of pixel in the second row is the same as that of a corresponding pixel (that is, in a same column) of the first row. Therefore, when applying the pixel driving method of the fourth embodiment to the pixel structure as shown in Fig.5a, by changing the polarity of the voltages of the data signals input to the data lines every two rows, so that the polarities of the voltage differences between the two transparent electrodes in a row are the same and the polarities of the voltage differences between the two transparent electrodes in two adjacent rows are contrary to each other, thus can achieve the pixel column-inversion according to the invention, as shown in Fig.5c.

With, the pixel driving method provided in the embodiment of the present invention, the voltages of the input data signals can be flipped every two rows, so that the pixel dot-inversion or the pixel column-inversion can be achieved, the power consumption can be reduced to a certain extent, and pixels can be pre-charged to a certain extent so as to ensure the time for charging.

Preferably, in embodiment of the present invention, when two adjacent frames of picture are displayed, the polarity of voltage of the data signal input to a data line can be changed from one frame to the other frame in the two adjacent frames, so that the polarities of the voltage differences between the two transparent electrode layers of the pixel in two adjacent frames are contrary to each other, and thus the pixel frame-inversion can be achieved.

The embodiment of the present disclosure further provides a display apparatus including any of pixel structures described in the above embodiments. The display apparatus can uses any of pixel driving methods provided in the above embodiments of the present disclosure according to requirement. It should be noted that the pixel unit, the pixel structure and the corresponding driving methods of the embodiments of the present disclosure can be applied to an ADS mode display apparatus, the pixel electrode and the common electrode are simplified as blocks for the sake of convenience.

## Claims

1. A driving method for an array formed by a plurality of pixel units of a liquid crystal display, wherein each of the pixel units comprises a first pixel (1) and a second pixel (2) and adopts a Dual Gate driving structure in which the first pixel (1) and the second pixel (2) are located in a same row parallel to a direction along which a gate line extends and are adjacent to each other, the first pixel (1) and the second pixel (2) comprising a first Thin Film Transistor TFT and a second TFT respectively, wherein, sources of the first and second TFTs are connected to a same data line (102), and gates of the first and second TFTs are connected to two adjacent gate lines (101a, 101b) respectively, the liquid crystal display comprising a first transparent electrode layer (104) formed in a first layer and a second transparent electrode layer (105) formed in another layer than the first layer;
in the first pixel (1), a part of the first transparent electrode layer (104) is connected to a drain (103cl) of the first TFT for driving the first pixel (1) and forms the pixel electrode of the first pixel (1), and a part of the second transparent electrode layer (105) forms the common electrode of the first pixel (1);
in the second pixel (2), a part of the second transparent electrode layer (105) is connected to a drain (103c2) of the second TFT for driving the second pixel (2) and forms the pixel electrode of the second pixel (2), and a part of the first transparent electrode layer (104) forms the common electrode of the second pixel (2);
wherein the first pixel (1) and the second pixel (2) are arranged alternately in each row, and each column comprises either only first pixels (1) or only second pixels (2)
**characterized in that** the pixel driving method comprises: in process of displaying a frame of picture, changing the polarity of the voltage of the data signal input to the data lines (102) every scanning of two adjacent gate lines, so that the polarities of the voltage differences between the first transparent electrode layer (104) and the second transparent electrode layer (105) in a same row are the same and the polarities of the voltage differences between the first transparent electrode layer (104) and the second transparent electrode layer (105) in two adjacent rows are contrary to each other, performing a dot inversion drive for the array of pixel units.

2. A driving method for an array formed by a plurality of pixel units of a liquid crystal display, wherein each of the pixel units comprises a first pixel (1) and a second pixel (2) and adopts a Dual Gate driving structure in which the first pixel (1) and the second pixel (2) are located in a same row parallel to a direction along which a gate line extends and are adjacent to each other, the first pixel (1) and the second pixel (2) comprising a first Thin Film Transistor TFT and a second TFT respectively, wherein, sources of the first and second TFTs are connected to a same data line (102), and gates of the first and second TFTs are connected to two adjacent gate lines (101a 101b) respectively, the liquid crystal display comprising a first transparent electrode layer (104) formed in a first layer and a second transparent electrode layer (105) formed in another layer than the first layer;
in the first pixel (1),a part of the first transparent electrode layer (104) is connected to a drain (103cl) of the first TFT for driving the first pixel (1) and forms the pixel electrode of the first pixel (1), and the second transparent electrode layer (105) forms the common electrode of the first pixel (1);
in the second pixel (2) a part of the second transparent electrode layer (105) is connected to a drain (103c2) of the second TFT for driving the second pixel (2) and forms the pixel electrode of the second pixel (2), and a part of the first transparent electrode layer (104) forms the common electrode of the second pixel (2);
wherein the first pixel (1) and the second pixel (2) are arranged alternately in each row and in each column,
**characterized in that** the pixel driving method comprises: in process of displaying a frame of picture, changing the polarity of the voltage of the data signal input to the data lines (102) every scanning of two adjacent gate lines, so that the polarities of the voltage differences between the first transparent electrode layer (104) and the second transparent electrode layer (105) in a same row are the same and the polarities of the voltage differences between the first transparent electrode layer (104) and the second transparent electrode layer (105) in two adjacent rows are contrary to each other, performing a column inversion drive for the array of pixel units.

3. The driving method of claim 1 or 2, wherein in process of displaying two adjacent frames of picture, the polarity of the voltage of the data signal input to each 5 of data lines (102) is changed, so that the polarities of the voltage differences between the first transparent electrode layer (104) and the second transparent electrode layer (105) of the same pixel (1, 2) in the two adjacent frames are contrary to each other.

## Patentansprüche

1. Ansteuerungsverfahren für ein Array, gebildet mittels einer Mehrzahl von Pixeleinheiten einer Flüssigkristallanzeige, wobei jede der Pixeleinheiten ein erstes Pixel (1) und ein zweites Pixel (2) umfasst und eine Dual Gate Ansteuerungsstruktur anwendet, wobei das erste Pixel (1) und das zweite Pixel (2) in einer gleichen Reihe parallel zu einer Richtung, entlang der sich eine Gate-Leitung erstreckt und benachbart zueinander lokalisiert sind, wobei das erste Pixel (1) und das zweite Pixel (2) einen ersten Dünnschichttransistor TFT und bzw. einen zweiten TFT umfassen, wobei Sources der ersten und zweiten TFTs an eine gleiche Datenleitung (102) angeschlossen sind und Gates des ersten und zweiten TFTs an zwei benachbarte Gate-Leitungen (101a, 101b) entsprechend angeschlossen sind, wobei die Flüssigkristallanzeige eine erste transparente Elektrodenschicht (104), die in einer ersten Schicht gebildet ist, und eine zweite transparente Elektrodenschicht (105), die in einer anderen Schicht als die erste Schicht gebildet ist, umfasst;
wobei in dem ersten Pixel (1) ein Teil der ersten transparenten Elektrodenschicht (104) mit einem Drain (103c1) des ersten TFT zum Ansteuern des ersten Pixels (1) verbunden ist und die Pixel-Elektrode des ersten Pixels (1) bildet, und wobei ein Teil der zweiten transparenten Elektrodenschicht (105) die gemeinsame Elektrode des ersten Pixels (1) bildet;
wobei in dem zweiten Pixel (2) ein Teil der zweiten transparenten Elektrodenschicht (105) mit einem Drain (103c2) des zweiten TFT zum Ansteuern des zweiten Pixels (2) verbunden ist und die Pixel-Elektrode des zweiten Pixels (2) bildet, und wobei ein Teil der ersten transparenten Elektrodenschicht (104) die gemeinsame Elektrode des zweiten Pixels (2) bildet;
wobei das erste Pixel (1) und das zweite Pixel (2) abwechselnd in jeder Reihe angeordnet sind, und wobei jede Spalte entweder nur erste Pixel (1) oder nur zweite Pixel (2) umfasst,
**dadurch gekennzeichnet, dass** das Pixelansteuerungsverfahren umfasst: im Vorgang der Anzeige eines Einzelbildes Wechseln der Polarität der Spannung des Datensignaleingangs zu den Datenleitungen (102) bei jedem Scannen von zwei benachbarten Gate-Leitungen, so dass die Polaritäten der Spannungsdifferenzen zwischen der ersten transparenten Elektrodenschicht (104) und der zweiten transparenten Elektrodenschicht (105) in einer gleichen Reihe die gleichen sind und die Polaritäten der Spannungsdifferenzen zwischen der ersten transparenten Elektrodenschicht (104) und der zweiten transparenten Elektrodenschicht (105) in zwei benachbarten Reihen gegensätzlich zueinander sind, unter Ausbildung einer Punktinversionsansteuerung für das Pixelunit-Array.

2. Ansteuerungsverfahren für ein Array, gebildet mittels einer Mehrzahl von Pixeleinheiten einer Flüssigkristallanzeige, wobei jede der Pixeleinheiten ein erstes Pixel (1) und ein zweites Pixel (2) umfasst und eine Dual Gate Ansteuerungsstruktur anwendet, wobei das erste Pixel (1) und das zweite Pixel (2) in einer gleichen Reihe parallel zu einer Richtung, entlang der sich eine Gate-Leitung erstreckt und benachbart zueinander lokalisiert sind, wobei das erste Pixel (1) und das zweite Pixel (2) einen ersten Dünnschichttransistor TFT und bzw. einen zweiten TFT umfassen, wobei Sources der ersten und zweiten TFTs an eine gleiche Datenleitung (102) angeschlossen sind und Gates des ersten und zweiten TFTs an zwei benachbarte Gate-Leitungen (101a, 101b) entsprechend angeschlossen sind, wobei die Flüssigkristallanzeige eine erste transparente Elektrodenschicht (104), die in einer ersten Schicht gebildet ist, und eine zweite transparente Elektrodenschicht (105), die in einer anderen Schicht als die erste Schicht gebildet ist, umfasst;
wobei in dem ersten Pixel (1) ein Teil der ersten transparenten Elektrodenschicht (104) mit einem Drain (103c1) des ersten TFT zum Ansteuern des ersten Pixels (1) verbunden ist und die Pixel-Elektrode des ersten Pixels (1) bildet, und wobei die zweite transparente Elektrodenschicht (105) die gemeinsame Elektrode des ersten Pixels (1) bildet;
wobei in dem zweiten Pixel (2) ein Teil der zweiten transparenten Elektrodenschicht (105) mit einem Drain (103c2) des zweiten TFT zum Ansteuern des zweiten Pixels (2) verbunden ist und die Pixel-Elektrode des zweiten Pixels (2) bildet, und wobei ein Teil der ersten transparenten Elektrodenschicht (104) die gemeinsame Elektrode des zweiten Pixels (2) bildet; wobei das erste Pixel (1) und das zweite Pixel (2) abwechselnd in jeder Reihe und in jeder Spalte angeordnet sind,
**dadurch gekennzeichnet, dass** das Pixelansteuerungsverfahren umfasst: im Vorgang der Anzeige eines Einzelbildes Wechseln der Polarität der Spannung des Datensignaleingangs zu den Datenleitungen (102) bei jedem Scannen von zwei benachbarten Gate-Leitungen, so dass die Polaritäten der Spannungsdifferenzen zwischen der ersten transparenten Elektrodenschicht (104) und der zweiten transparenten Elektrodenschicht (105) in einer gleichen Reihe die gleichen sind und die Polaritäten der Spannungsdifferenzen zwischen der ersten transparenten Elektrodenschicht (104) und der zweiten transparenten Elektrodenschicht (105) in zwei benachbarten Reihen gegensätzlich zueinander sind, unter Ausbildung einer Spalteninversionsansteuerung für das Pixelunitarray.

3. Ansteuerungsverfahren gemäß Anspruch 1 oder 2, wobei im Vorgang der Anzeige von zwei benachbarten Einzelbildern die Polarität der Spannung des Datensignaleingangs zu jeder der Datenleitungen (102) geändert wird, so dass die Polaritäten der Spannungsdifferenzen zwischen der ersten transparenten Elektrodenschicht (104) und der zweiten transparenten Elektrodenschicht (105) des gleichen Pixels (1, 2) in den zwei benachbarten Einzelbildern gegensätzlich zueinander sind.

## Revendications

1. Un procédé de commande pour une matrice formée par une pluralité d'unités de pixel d'un afficheur à cristaux liquides, dans lequel chacune des unités de pixel comprend un premier pixel (1) et un deuxième pixel (2) et adopte une structure de commande à deux grilles dans lequel le premier pixel (1) et le deuxième pixel (2) sont situés dans une même rangée parallèle à une direction le long de laquelle s'étend une ligne de grille et sont adjacents l'un de l'autre, le premier pixel (1) et le deuxième pixel (2) comprenant un premier transistor à couches minces et un deuxième transistor à couches minces respectivement, dans lequel des sources des premier et deuxième transistors à couches minces sont connectées à une même ligne de données (102) et des grilles des premier et deuxième transistors à couches minces sont connectées à deux lignes de grille adjacentes (101a, 101b) respectivement, l'afficheur à cristaux liquides comprenant une première couche d'électrodes transparentes (104) formée dans une première couche et une deuxième couche d'électrode transparente (105) formée dans une couche autre que la première couche ;
dans le premier pixel (1), une partie de la première couche d'électrodes transparentes (104) est connectée à un drain (103c1) du premier transistor à couches minces pour commander le premier pixel (1) et forme l'électrode du premier pixel (1), et une partie de la deuxième couche d'électrodes transparentes (105) forme l'électrode commune (105) du premier pixel (1) ;
dans le deuxième pixel (2), une partie de la deuxième couche d'électrodes transparentes (105) est connectée à un drain (103c2) du deuxième transistor à couches minces pour commander le deuxième pixel (2) et forme l'électrode de pixel du deuxième pixel (2), et une partie de la première couche d'électrodes transparentes (104) forme l'électrode commune du deuxième pixel (2) ;
dans lequel le premier pixel (1) et le deuxième pixel (2) sont agencés en alternance dans chaque rangée, et chaque colonne comprend soit uniquement des premiers pixels (1), soit uniquement des deuxièmes pixels (2)
**caractérisé en ce que** le procédé de commande de pixels comprend : dans le processus d'affichage d'une trame d'image, changer la polarité de la tension du signal de données appliqué en entrée aux lignes de données (102) à chaque balayage de deux lignes de grille adjacentes de manière à ce que les polarités des différences de tension entre la première couche d'électrodes transparentes (104) et la deuxième couche d'électrodes transparentes (105) dans une même rangée soient les mêmes et les polarités des différences de tension entre la première couche d'électrodes transparentes (104) et la deuxième couche d'électrodes transparentes (105) dans deux rangées adjacentes soient contraires l'une à l'autre, réalisant une commande d'inversion de points pour la matrice d'unités de pixel.

2. Un procédé de commande pour une matrice formée par une pluralité d'unités de pixel d'un afficheur à cristaux liquides, dans lequel chacune des unités de pixel comprend un premier pixel (1) et un deuxième pixel (2) et adopte une structure de commande à deux grilles dans lequel le premier pixel (1) et le deuxième pixel (2) sont situés dans une même rangée parallèle à une direction le long de laquelle s'étend une ligne de grille et sont adjacents l'un de l'autre, le premier pixel (1) et le deuxième pixel (2) comprenant un premier transistor à couches minces et un deuxième transistor à couches minces respectivement, dans lequel des sources des premier et deuxième transistors à couches minces sont connectées à une même ligne de données (102) et des grilles des premier et deuxième transistors à couches minces sont connectées à deux lignes de grille adjacentes (101a, 101b) respectivement, l'afficheur à cristaux liquides comprenant une première couche d'électrodes transparentes (104) formée dans une première couche et une deuxième couche d'électrodes transparentes (105) formée dans une couche autre que la première couche ;
dans le premier pixel (1), une partie de la première couche d'électrodes transparentes (104) est connectée à un drain (103c1) du premier transistor à couches minces pour commander le premier pixel (1) et forme l'électrode du premier pixel (1), et la deuxième couche d'électrodes transparentes (105) forme l'électrode commune (105) du premier pixel (1) ;
dans le deuxième pixel (2), une partie de la deuxième couche d'électrodes transparentes (105) est connectée à un drain (103c2) du deuxième transistor à couches minces pour commander le deuxième pixel (2) et forme l'électrode de pixel du deuxième pixel (2), et une partie de la première couche d'électrodes transparentes (104) forme l'électrode commune du deuxième pixel (2) ;
dans lequel le premier pixel (1) et le deuxième pixel (2) sont agencés en alternance dans chaque rangée et dans chaque colonne,
**caractérisé en ce que** le procédé de commande de pixels comprend : dans le processus d'affichage d'une trame d'image, changer la polarité de la tension du signal de données appliqué en entrée aux lignes de données (102) à chaque balayage de deux lignes de grille adjacentes de manière à ce que les polarités des différences de tension entre la première couche d'électrodes transparentes (104) et la deuxième couche d'électrodes transparentes (105) dans une même rangée soient les mêmes et les polarités des différences de tension entre la première couche d'électrodes transparentes (104) et la deuxième couche d'électrodes transparentes (105) dans deux rangées adjacentes soient contraires l'une à l'autre, réalisant une commande d'inversion de colonnes pour la matrice d'unités de pixel.

3. Le procédé de commande selon la revendication 1 ou 2, dans lequel dans le processus d'affichage de deux trames adjacentes d'image, la polarité de la tension du signal de données appliqué en entrée de chacune des lignes de données (102) est changée de manière à ce que les polarités des différences de tension entre la première couche d'électrodes transparentes (104) et la deuxième couche d'électrodes transparentes (105) du même pixel (1, 2) dans les deux trames adjacentes soient contraires l'une à l'autre.
